(19)

**Europäisches Patentamt**
**European Patent Office**
**Office européen des brevets**

(11)  **EP 1 743 184 B1**

(12)  # EUROPÄISCHE PATENTSCHRIFT

(45) Veröffentlichungstag und Bekanntmachung des Hinweises auf die Patenterteilung:
**21.12.2011  Patentblatt 2011/51**

(21) Anmeldenummer: **05742687.6**

(22) Anmeldetag: **15.04.2005**

(51) Int Cl.:
**G01R 31/36** $^{(2006.01)}$

(86) Internationale Anmeldenummer:
**PCT/EP2005/051669**

(87) Internationale Veröffentlichungsnummer:
**WO 2005/103745 (03.11.2005 Gazette 2005/44)**

(54) **VERFAHREN UND ANORDNUNG ZUR ERMITTLUNG VON BETRIEBSPARAMETERN EINER ELEKTROCHEMISCHEN SPEICHERBATTERIE**

METHOD AND ARRANGEMENT FOR DETERMINING OPERATING PARAMETERS OF AN ELECTROCHEMICAL STORAGE BATTERY

PROCEDE ET DISPOSITIF POUR DETERMINER DES PARAMETRES DE FONCTIONNEMENT D'UN ACCUMULATEUR ELECTROCHIMIQUE

(84) Benannte Vertragsstaaten:
**DE ES FR GB IT**

(30) Priorität: **23.04.2004  DE 102004020412**
**06.04.2005  DE 102005015729**

(43) Veröffentlichungstag der Anmeldung:
**17.01.2007  Patentblatt 2007/03**

(73) Patentinhaber: **ROBERT BOSCH GMBH**
**70442 Stuttgart (DE)**

(72) Erfinder:
• **EHRET, Christine**
**89275 Thalfingen (DE)**
• **HEINZE, Daniel**
**39106 Magdeburg (DE)**
• **JOSSEN, Andreas**
**89340 Leipheim (DE)**
• **SPAETH, Volker**
**89257 Betlinshausen (DE)**

(56) Entgegenhaltungen:
WO-A-03/001224      DE-B3- 10 216 637
US-A- 6 127 806      US-A- 6 163 133

• SAUER D U: "Modelling of local conditions in flooded lead/acid batteries in photovoltaic systems" JOURNAL OF POWER SOURCES, ELSEVIER, AMSTERDAM, NL, Bd. 64, Nr. 1-2, Januar 1996 (1996-01), Seiten 181-187, XP004075209 ISSN: 0378-7753
• PILLER S ET AL: "Methods for state-of-charge determination and their applications" JOURNAL OF POWER SOURCES, ELSEVIER, AMSTERDAM, NL, Bd. 96, Nr. 1, 1. Juni 2001 (2001-06-01), Seiten 113-120, XP004298736 ISSN: 0378-7753

**Beschreibung**

Die Erfindung betrifft ein Verfahren zur Ermittlung einer Säurekapazität als Betriebspmmeter einer elektrochemischen Speicherbatterie ausgebildet durch eine Blei-Säure-Batterie unter Berücksichtigung einer Elekhrolytschichtung.

Ein Beispiel, das das Verständnis der Erfindung erleichtert, ist eine Anordnung zur Ermittlung von Betriebsparametern einer elektrochemischen Speicherbatterie mit Mitteln zur Bestimmung der Batteriespannung und des Batteriestroms, mit Speicher zum Ablegen der Nennkapazität der Speicherbatterie, und mit Rechnermitteln.

In Speicherbatterien, insbesondere in Blei-Säure-Batterien, die ausgesprochenen Zyklen betrieb unterliegen, bildet sich eine Elektrolytschichtung aus. Sie tritt insbesondere dann verstärkt auf, wenn die Speicherbatterien sehr tief entladen werden.

Die Elekirolytschichtung bewirkt, dass bei einer geschichteten elektrochemischen Speicherbatterie nicht mehr die gesamte Kapazität einer ungeschichteten (ohne Elektrolytschichtung) Speicherbatterie zur Verfügung steht.

Moderne Fahrzeugbatterien werden sehr oft auch in niedrigen Ladezuständen betrieben, wodurch Elektrolytschichtung verursacht wird. Bei Fahrzeugen mit hohem Komfort sind nämlich Verbraucher bei abgestellten Fahrzeug aktiv (Ruhestrom des Fahrzeugs) bzw. werden vom Fahrer aktiviert (Standheizung, Sitzverstellung, Fernseher, etc.). Die Elektrolytschichtung wirkt sich dabei bei Fahrzeugen mit hohem Komfort sehr stark auf die Verfiigbarkeit dieser Komfortverbraucher aus. Sie müssen früher abgeschaltet werden, um bevorzugte Funktionen, wie zum Beispiel den Start des Fahrzeugs, gewährleisten zu können.

Elektrolytschichtung kann nicht vollständig aufgehoben werden. Allerdings kann durch eine sehr starke Ladung beispielsweise einer 12 V-Batterie bei 16 V über eine sehr lange Zeit die Schichtung wieder sehr stark vermindert werden. Im Fahrzeugbetrieb wird die Batterie meistens bei niedriger Spannung geladen (maximal 14,7 V), bei Fahrzeugen der Oberklasse aber tief entladen. Das Anheben der Ladespannung auf 16 V bzw. eine Optimierung des Ladeverfahrens zur Verringerung der entstehenden Elektrolytschichtung ist oft nur mit einem unerwünschten Eingriff in das Energiemanagment des Fahrzeugs verbunden. Die Batterie wird in solchen Fahrzeugen nie vollgeladen, so dass eine Schichtung nicht abgebaut werden kann.

Aus der DE 101 06 508 AI ist ein Verfahren zum Abschätzen der Leistungsfähigkeit einer Speicherbatterie unter Berücksichtigung der Elektrolytschichtung aus der Batterieklemmenspannung, dem Batteriestrom und der Batterietemperatur bekannt. Hierzu wird ein durch Dichteunterschiede in der Batteriesäure verursachter innerer Spannungsabfall der Batterie, eine Ruhespannung und ein Innenwiderstand abgeschätzt und die Leistungsfähigkeit mit einem die Batterie beschreibenden Modell bestimmt.

Aufgabe der Erfindung ist es, ein verbessertes Verfahren zur Ermittlung von Betriebsparametern einer elektrochemischen Speicherbatterie unter Berücksichtigung einer Elekirolytschichtung zu schaffen, insbesondere um die Säurekapazität und damit die IST-Kapazität der Speicherbatterie noch einfacher und zuverlässiger zu bestimmen, die bei vorhandener Schichtung noch zur Verfügung steht

Die Aufgabe wird mit dem gattungsgemäßen Verfahren erfindungsgemäß gelöst durch die schritte, die in Anspruch 1 definiert werden.

Das Verfahren basiert auf der Erkenntnis, dass sich die Lade- und Entladekennlinien der über den Ladezustand SOC aufgetragenen Ruhespannung $U_0$ bei Elektrolytschichtung hinsichtlich der entsprechenden Kennlinien der Speicherbatterie ohne Elekirolytschichtung beeinflussen. Dabei hat sich gezeigt, dass sich die Lade- und Entladekennlinien unterschiedlich verhalten. Während bei Ladung der Speicherbatterie eine Gerade als Kennlinie resultiert, besteht die Entladekennlinie aus zwei geraden Teilen mit unterschiedlicher Steigung. Die steile Gerade im oberen Wertebereich des Ladezustands SOC wird als erster funktionaler Zusammenhang und eine flache Gerade im unteren Wertebereich des Ladezustands SOC als zweiter funktionaler Zusammenhang bezeichnet. Die Steigerung der Geraden und der Schnittpunkt zwischen diesen funktionalen Zusammenhängen ändern sich im Verlauf des Vorgangs der Elektrolytschichtung.

Das Verschieben der zweiten Kennlinie nach unten verursacht eine Beeinflussung des Offsets der ersten Kennlinie und das Verschieben der ersten Kennlinie nach links verursacht eine Beeinflussung des Offsets der zweite Kennlinie. Die ungeschichtete Kennlinie dient dazu, diese Offsets zwischen den jeweiligen Kennlinien und der ungeschichteten Kennlinie zu bestimmen.

Bei dem erfindungsgemäßen Verfahren wird nunmehr vorgeschlagen, die Änderung des Schnittpunkts der flachen Geraden der Entladekennlinie im unteren Wertebereich des Ladezustands (zweiter fimktionaler Zusammenhang) mit der steilen Geraden im oberen Wertebereich des Ladezustands SOC (erster funktionaler Zusammenhang) auszuwerten, um auf Betriebsparameter zu schließen. Weiterhin wird vorgeschlagen, die Steigungen der Geraden als Parameter zur Bestimmung von Betriebsparametem zu nutzen.

Als Betriebsparameter kann beispielsweise ein korrigierter Ladezustandswert SOC, ein korrigierter Ruhespannungswert $U_0$ und/oder die Säurekapazität der Speicherbatterie und/oder die entnehmbare Ladung unter Nennbedingung mit dem erfindungsgemäßen Verfahren bestimmt werden. Dabei kann beispielsweise beim Einbau einer neuen Batterie in ein Fahrzeug an Hand der berechneten Säurekapazität erkannt werden, ob eine völlig falsche Batteriegröße verbaut wurde.

Weiterhin ist es vorteilhaft, einen dritten funktionalen Zusammenhang zwischen der Ruhespannung $U_0$ und dem Ladezustand SOC als Wert für die entnehmbare Ladung bezogen auf die Nennkapazität der Speicherbatterie im Zustand ohne Elektrolytschichtung zu bestimmen. Dann kann die durch den ersten und zweiten funktionalen Zusammenhang beschriebene Entladekennlinie im Bezug auf die Kennlinie einer ungeschichteten Batterie, d.h. den dritten funktionalen Zusammenhang ausgewertet werden.

Vorzugsweise wird ein korrigierter Ladezustandswert und/oder korrigierter Ruhespannungswert der Speicherbatterie in Abhängigkeit von dem Spannungsoffset und der Steigung der Geraden zur Beschreibung der Geraden zur Beschreibung des ersten und zweiten funktionalen Zusammenhangs mit ermittelt.

Die Säurekapazität der Speicherbatterie wird bevorzugt als Betriebsparameter aus der Steigung einer Geraden zur Beschreibung des ersten oder zweiten funktionalen Zusammenhangs, insbesondere aus dem jeweils aktiven funktionalen Zusammenhang bestimmt. Dabei kann die Säurekapazität auf zwei unterschiedliche Arten berechnet werden, nämlich entweder aus den ermittelten Parametern Steigung und Spannungsoffset oder aus zwei gemessenen bzw. ermittelten Ruhespannungswerten.

In beiden Ausführungsformen kann die Säurekapazität aus der Steigung der Geraden zur Beschreibung des ersten funktionalen Zusammenhangs ermittelt werden, wenn die Ruhespannung größer oder gleich der Ruhespannung an dem Schnittpunkt der beiden durch den ersten und zweiten funktionalen Zusammenhang ausgedrückten Geradenabschnitte der Geradekennlinie ist. Andernfalls, wenn die Ruhespannung kleiner als die Ruhespannung am Schnittpunkt der beiden Geradenabschnitte der Entladungskennlinie ist, wird die Säurekapazität aus der Steigung der Geraden zur Beschreibung des zweiten funktionalen Zusammenhangs ermittelt.

Die Säureka.pazität kann auf die zweite Art aus den gemessenen oder ermittelten Ruhespannungswerten beispielsweise nach der Beziehung:

$$C_{0,x} = (U_{0,1x} - U_{0,2x})/\text{Ladungsumatz}$$

mit $U_{0,1x}$ und $U_{0,2x}$ als Ruhespannungswerte $U_0$ auf der Kennlinie entweder des ersten (x=1) oder des zweiten (x=2) funktionalen Zusammenhangs und dem Ladungsumsatz zwischen der Bestimmung der beiden Ruhespannungswerte $U_{0,1x}$ und $U_{0,2x}$ ermittelt werden.

Es ist weiterhin vorteilhaft, wenn die Betriebsparameter in Abhängigkeit von der Temperatur, d.h. der Batterietemperatur oder einer der Batterietemperatur entsprechenden Temperaturgröße ermittelt wird.

Ein Beispiel, das das Verständnis des Erfindund erleichtert, ist eine Anordnung zur Ermittlung von Betriebsparametern einer elektrochemischen Speicherbatterie mit Mitteln zur Bestimmung der Batteriespannung und des Batteriestrom und mit Speicher zum Ablegen der Nennkapazität der Speicherbatterie und mit Rechnermitteln zur Durchführung des oben beschriebenen Verfahrens. Die Rechnermittel können beispielsweise als programmierter Mikrocontroller eines Kraftfahrzeuges ausgebildet sein.

Die Erfindung wird nachfolgend an Hand der beigefügten Zeichnungen beispielhaft näher erläutert. Es zeigen:

Figur 1 - Blockdiagramm einer Anordnung zur Ermittlung der korrigierten Ruhespannung, Säurekapazität und entnehmbaren Ladung einer elektrochemischen Speicherbatterie mit dem erfindungsgemäßen Verfahren;

Figur 2 - Kennliniendiagramme der über den Ladezustand aufgetragenen Ruhespannungen einer ungeschichteten Batterie, einer geschichteten Batterie bei Ladung und einer geschichteten Batterie bei Entladung;

Figur 3 - Kennliniendiagramme der als über den Ladezustand aufgetragenen Ruhespannung einer ungeschichteten Batterie und einer geschichteten Batterie bei Entladung im oberen Wertebereich des Ladezustands als erster funktionalen Zusammenhang sowie mit Verschiebung der Kennlinie mit zunehmender Elektrolytschichtung;

Figur 4 - Kennliniendiagramm als über den Ladezustand aufgetragenen Ruhespannung einer ungeschichteten Batterie und einer geschichteten Batterie bei Entladung im unterer Wertebereich des Ladezustands als zweiten funktionalen Zusammenhang sowie mit > Verschiebung der Kennlinie mit zunehmender Elektrolytschichung;

Figur 5 - Kennliniendiagramm einer ungeschichteten Batterie und einer geschichteten Batterie bei Entladung als über den Ladezustand aufgetragene Ruhespannung und des Spannungsoffsets für den ersten funktionalen Zusammenhang;

Figur 6 - Diagramm des über den Ladungsumsatz seit der letzten Volladung oder längeren Ruhephase aufgetragenen korrigierten Ruhespannungs-Offsets des ersten funktionalen Zusammenhangs;

Figur 7 - Liniendiagramm einer geschichteten und einer ungeschichteten Batterie bei Entladung als über den Ladezustand aufgetragene Ruhespannung und des Offsets für den zweiten funktionalen Zusammenhangs;

Figur 8 - Diagramm des über den gesamten Ladungsumsatzes aufgetragenen Ruhespannungs-Offsets des zweiten funktionalen Zusammenhangs.

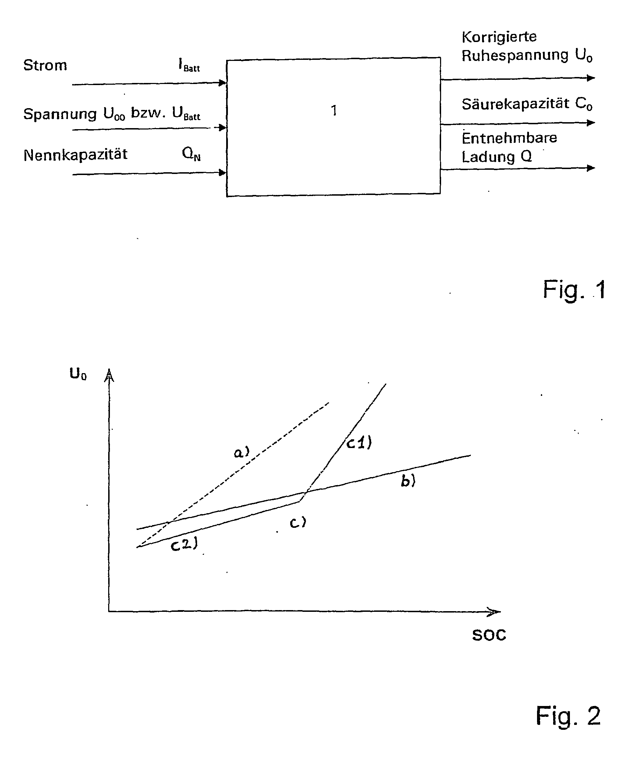

Die Figur 1 lässt ein Blockdiagramm einer Anordnung 1 zur Ermittlung einer korrigierten Ruhespannung $U_0$ und der Säurekapazität $C_0$ einer Speicherbatterie als Betriebsparameter und der entnehmbaren Ladung Q unter Berücksichtigung einer Elektrolytschichtung aus den Messgrößen Batteriespannung UBatb Batteriestrom $I_{Batt}$ und der Nennkapazität $Q_N$ erkennen. Hierzu hat die Anordnung in bekannter Weise Messmittel für den Batleriestrom $I_{Batt}$ und die Batteriespannung $U_{Batt}$ sowie Speicher zum Ablegen des Wertes der Nennkapazität $Q_N$ der Speicherbatterie. Die Anordnung selbst kann beispielsweise als programmierter Mikrocontroller realisiert werden.

Die Ruhespannung $U_0$ bzw. der Ladezustand SOC wird durch die Anordnung mit Hilfe eines Spannungsoffsets $U_{Offset}$ und der Steigung a von Kennlinien zur Beschreibung eines ersten oder zweiten funktionalen Zusammenhangs zwischen der Ruhespannung $U_0$ und dem Ladezustand SOC ermittelt. Der Ladezustand SOC ist hierbei der auf der Nennkapazität $Q_N$ bezogene Wert für die Speicher batterie noch entnehmbare Ladung Q. Die Säurekapazität $C_0$ kann, wie nachfolgend im einzelnen detailliert erläutert wird, mit zwei unterschiedlichen Methoden bestimmt werden. Zum einen kann die Säurekapazität $C_0$ aus der Steigung der jeweils aktiven Entladekennlinie der Speicherbatterie mit Elektrolytschichtung, d.h. nach der Gleichung:

$$C_{0,X} = (S_U - UO, X_{korr})/(S_{SOC} - SOCX_{korr})$$

mit dem aktiven ersten oder zweiten funktionalen Zusammenhang bestimmt werden. Zum anderen kann die Säurekapazität $C_0$ durch Bestimmung von zwei Ruhephasen auf jeweils einem Teil der Entladekennlinie, d.h. entweder mit dem ersten oder dem zweiten funktionalen Zusammenhang nach der Gleichung

$$C_{0,kx} = (U_{0,1x} - U_{0,2x})/\text{Ladungsumsatz}$$

bestimmt werden. Hierbei wird mit x=1 der erste funktionale Zusammenhang gewählt, wenn die Ruhespannung $U_0$ größer oder gleich als die Ruhespannung $S_U$ im Schnittpunkt der beiden Kennlinien des ersten und zweiten funktionalen Zusammenhangs ist.

Hingegen wird mit x=2 der zweite funktionale Zusammenhang gewählt, wenn die Ruhespannung $U_0$ kleiner als die Ruhespannung $S_U$ am Schnittpunkt ist.

Die Figur 2 lässt ein Diagramm von Ruhespannungskennlinien über den Ladezustand SOC für die Ladekennlinie einer geschichteten Speicherbatterie (Kennlinie a)) eine ungeschichtete Speicherbatterie (Kennlinie b)), und die Entladekennlinie einer geschichteten Speicherbatterie (Kennlinie c)) erkennen. Die Entladekennlinie c) besteht aus einem ersten steilen Geradenabschnitt im oberen Wertebereich des Ladezustands SOC (erster funktionaler Zusammenhang bzw. Gerade c1) und einem flacheren Geradenabschnitt im unteren Wertebereich des Ladezustands SOC (zweiter funktionaler Zusammenhang bzw. Gerade c2).

Das erfindungsgemäße Verfahren ist somit dadurch gekennzeichnet, dass in der Modellbetrachtung wie auch in den Messungen die Entladekennlinie c) in zwei Geradenteile unterschiedlicher Steigung c1, c2 geteilt ist. Dies kann wie folgt physikalisch begründet werden.

Der Elektrolyt einer Speicherbatterie kann grob in drei Bereiche eingeteilt werden. Der erste Bereich wird durch den Elektrolyten über den Platten gebildet, der nicht an der Reaktion teilnimmt. Der zweite Bereich wird durch ein mittleren Elektrolytbereich bestimmt, dessen Elektrolyt zweite Gerade im unteren Wertebereich des Ladezustands SOC beeinflusst. Der dritte Bereich wird durch einen unteren Elektrolyfbereicb bestimmt, der die obere steilere Gerade cl der Entladekennlinie beeinflusst. Dabei ist der untere Elek.1rolytbereich kleinere als der mittlere Elektrolytbereich. Der Übergang von der kleineren zur größeren Elektrolytmenge wird zudem nicht wie in der Realität als fließend, sondern zu einem bestimmten Zeitpunkt angenommen. In der Modellbetrachtung ist dies der Schnittpunkt der beiden Geradenabschnitte der Entladekennlinie. In einer geschichteten Speicherbatterie wird der untere Plattenteil mit höher konzentrierter Säure stärker entladen und schwächer geladen. Dieser ist bestimmt für die Ruhespannung $U_0$.

Mit dem erfindungsgemäßen Verfahren werden nun Betriebsparameter der elektrochemischen Speicherbatterie aus dem sich mit zunehmender Elekirolytschichtung ändernden Schnittpunkt der beiden Geradenabschnitte der Entladekennlinie, aus den Steigungen der Geradenabschnitte in Abhängigkeit vom gesamten Ladungsumsatz (Gerade c2) und dem Ladungsumsatz seit der letzten Ruhephase oder Vollladung (Gerade c1) ermittelt

Durch die sich in Abhängigkeit von der Säurekapazität ändernde Steigung und die Verschiebung des Schnittpunktes der Entladekennlinie bei sich änderndem Schichtungsgrad kann eine Korrektur des Ladezustandswertes SOC bzw. der Ruhespannung $U_0$ in Ruhephasen sowie eine Bestimmung der Säurekapazität stattfinden. Für die Betrachtung der Eleldrolytschichtung wird die geschichtete Speicherbatterie modellarig in drei Schichten mit unterschiedlicher Säuredichte und Elektrolytmenge aufgeteilt:

a) eine obere Schicht, deren Elektrolyt nicht an den Reaktionen teilnimmt;

b) eine mittlere Schicht, deren Elektrolytmenge und Säuredichte Einfluss auf die flachere Gerade c2) im unteren Wertebereich des Ladezustands SOC der Entladekennlinie nimmt;

c) eine untere Schicht, deren Elektrolytmenge und Säuredichte Einfluss auf die steilere Gerade c1) im oberen Wertebereich des Ladezustands SOC der Entladekennlinie nimmt

Weiterhin wird zwischen dem gesamten Ladungsumsatz und dem Ladungsumsatz seit der letzten längeren Ruhephase oder Vollladung unterschieden, da jeweils ein anderer Geradenabschnitt der Entladekennlinie beeinflusst wird. Der gesamte Ladungsumsatz beeinflusst die Gerade c2), d.h. den zweiten funktionalen Zusammenhang maßgeblich. Durch den Ladungsdurchsatz seit der letzten Vorladung oder längeren Ruhephase wird die Gerade c1) der Entladekennlinie, d.h. der erste funktionale Zusammenhang beeinflusst.

Durch eine Vollladung werden beide Geradenabschnitte c1) und c2) der Entladekennlinie beeinflusst. Es findet ein Ausgleich der Säuredichte auf Grund von Gasung statt. Damit wird die Säuredichte im unteren Teil der Speicherbatterie geringer und die Säuremenge kleiner. Die Ruhespannung nimmt ab. Der erste funktionale Zusammenhang (Geradenabschnitt c1) der Entladekennlinie c) wird durch eine Verringerung der Säurekonzentration und des Elektrolytvolumens im unteren Teil der Speicherbatterie beeinflusst und damit auch der Geradenabschnitt c2) (zweiter funktionale Zusammenhang), da im mittleren Elektrolytbereich eine stärke Ladung statt6ndet.

In den Ruhephasen stattfmdende Umladungsprozesse bewirken einen Konzentrationsausgleich in der Säure. Dies bedeutet, dass sowohl der Geradenabschnitt c1) als auch der Geradenabschnitt c2) der Entladekennlinie c) beeinflusst werden. Der untere Plattenteil wird somit weiter entladen. Dies kann dazu führen, dass der untere Plattenteil nicht mehr an der Reaktion teilnehmen kann. Dies bedeutet wiederum, dass sich die Elektrolytmenge im mittleren Teil der Platten verringert.

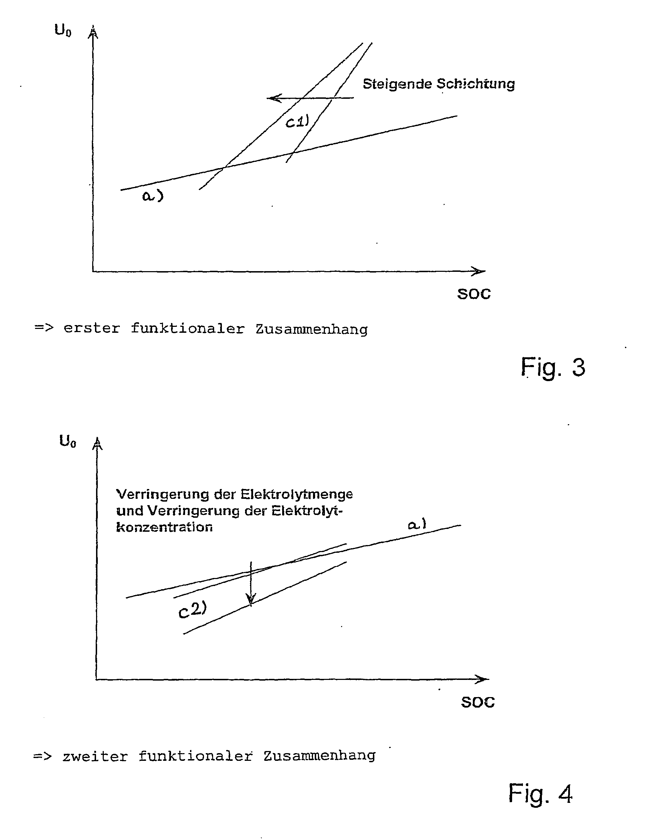

Die Figur 3 lässt ein Diagramm des Geradenabschnitts c1) der Entladekennlinie c) sowie die Kennlinie a) einer ungeschichteten Speicherbatterie als über den Ladezustand SOC aufgetragene Ruhespannung $U_0$ erkennen. Der den ersten funktionalen Zusammenhang zwischen der Ruhespannung $U_0$ und dem Ladezustand SOC der geschichteten Speicherbatterie beschreibende Geradenabschnitt c1) wird durch die Dichte und die Menge des unteren Elektrolytbereichs bestimmt. Die Dichte und Menge des unteren Elektrolytbereichs steigen mit zunehmender Elekirolytschichtung, das heißt mit dem Ladungsumsatz seit der letzten Volladung oder längeren Ruhephase an. Mit zunehmender Säurerlichte wird die Kennlinie c) und damit der Schnittpunkt mit der den zweiten funktionalen Zusammenhang beschreibenden Geraden c2) nach links verschoben. Mit wachsender Elektrolytmenge wird die Steigung der Geradenabschnitte c1) und c2) flacher und der Schnittpunkt weiter nach links verschoben.

Ein steiler Anstieg der den ersten funktionalen Zusammenhang beschreibenden Graden 1 lässt auf einen kleinen Schichtungsgrad schließen, der nach einem kleinen Ladungsumsatz, einer Vollladung oder einer längeren Ruhephase zu erwarten ist.

Ein flacher Anstieg hingegen lässt auf höhere Schichtungen schließen.

Die Figur 4 lässt die Kennlinie a) einer ungeschichteten Speicherbatterie sowie den Geradenabschnitt c2), der den zweiten funktionalen Zusammenhang zwischen der Ruhespannung $U_0$ und dem Ladezustand SOC der geschichteten Speicherbatterie als Entladekennlinie beschreibt, erkennen.

Die Änderung des Geradenabschnitts c2) wird durch den Verlust am nutzbarem Elektrolyt bestimmt, welcher durch den niedrigen Ladezustand SOC im unteren Plattenbereich ausgelöst wird. Eine geringere Elektrolytmenge bewirkt eine steilere Kennlinie des Geradenabschnitts c2). Die daraus resultierende geringere Säuredichte in der Schicht bewirkt eine Verschiebung des Geradenabschnitts c2) nach unten. Auch der nicht nutzbare Elektrolyt über den Platten, welcher auf Grund seiner geringeren Dichte nicht mehr nutzbar ist, verringert die nutzbare Elektrolytmenge im Bereich des Geradenabschnitts c2). Nach kurzer Betriebszeit ist dieser Elektrolytbereich konstant, was zu einem leichten Anstieg der Steigung zu Beginn der Betriebszeit führt. Durch die leichte Konzentrationserhöhung des nutzbaren Elektrolyten wird die Ruhespannung $U_0$ im oberen Ladebereich SOC etwas erhöht.

Die nutzbare Elektrolytmenge und Elektrolytkonzentration kann durch Vollladung und längere Ruhephasen mit anschließender Ladung wieder erhöht werden. Näherungsweise gibt ein flacher Anstieg des Geradenabschnitts c2) die Anstiegserhöhung zu Beginn der Betriebszeit und ein steiler Anstieg den weiteren Elekirolytverlust durch den entladenden unteren Plattenbereich wieder.

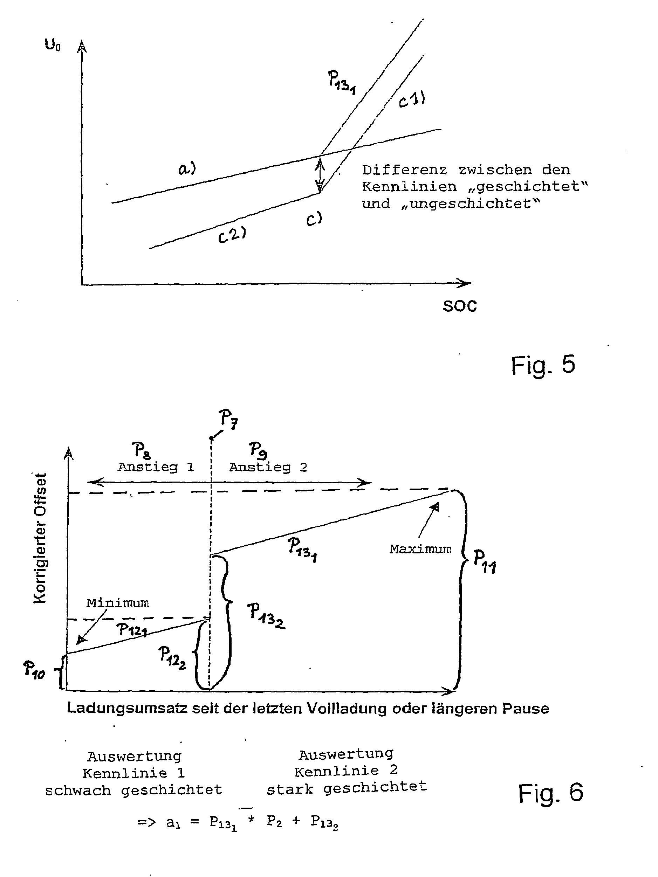

Die Figur 5 lässt die Kennlinie a) einer ungeschichteten Speicher batterie und die Entladekennline c) jeweils als funktionale Zusammenhänge zwischen der Ruhespannung $U_0$ und dem Ladezustand SOC erkennen.

Es wird deutlich, dass eine Verschiebung des Geradenabschnitts c2) auf Grund einer Verringerung der Elektrolytmenge und Verringerung der Elektrolytkonzentration nach unten, das Verschieben des Ruhespannungs-Offset $U_{0,Offset}$ des oberen Geradenabschnitts c1) verursacht. Dieser Ruhespannungs-Offset $U_{0,Offset}$ wird korrigiert, indem der Geradenabschnitt c1) auf die Kennlinie einer ungeschichteten Speicher batterie normiert wird. Es wird also die Differenz zwischen dem Schnittpunkt des Geradenabschnitts c1) und des Geradenabschnitts c2) der Entladekennlinie zu der Kennlinie der ungeschichteten Speicherbatterie ermittelt.

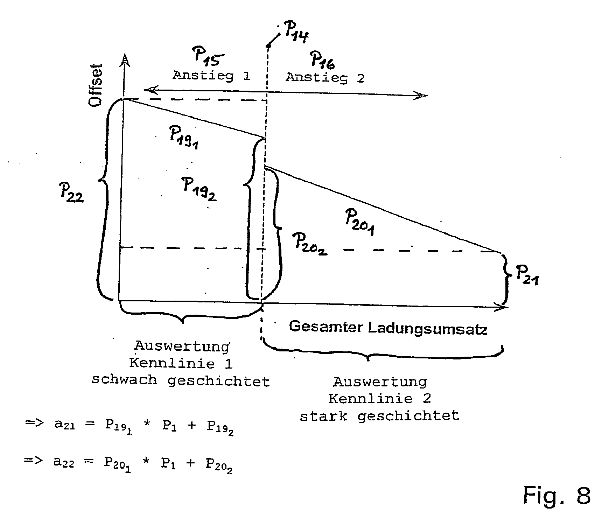

Die Kennlinien zur Bestimmung der Offsets $a_{21}$, $a_{22}$ des zweiten funktionalen Zusammenhang bzw. $a_1$ des ersten funktionalen Zusammenhangs werden wie in den Figuren 6 und 8 gezeigt, folgendermaßen hergestellt:

1.) Bestimmung eines minimalen Offsetwertes $P_{10}$, $P_{21}$ und maximalen Ossetwertes $P_{11}$, $P_{22}$.

Der minimale Offsetwert ist der Offset, an den die Kennlinie durch Vollladung und Ruhephase höchstens zurückgeschoben werden kann.

Der maximale Offsetwert ist der Offset, an den die Kennlinie durch eine Schichtung maximal verschoben werden kann.

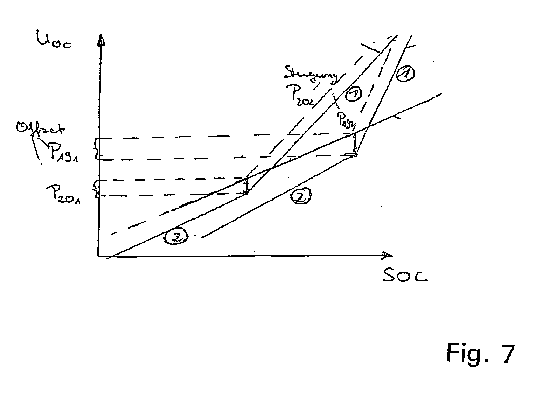

2.) Bestimmung der Offsetwerte $P12_2$, $P13_2$ bzw. $P19_2$, $P20_2$ wie in den Figuren 5 und 7 dargestellt ist, werden die Kennlinien auf die ungeschichtete Kennlinie normiert. Hierzu wird die Differenz zwischen dem Schnittpunkt der ersten und zweiten Kennlinie und der umgeschichten Kennlinie zum Offset hinzu addiert.

3.) Aus der Darstellung der gemäß Figuren 6 und 8 wird dann die jeweilige Steigung $P12_1$, $P13_1$ bzw. $P19_1$, $P20_1$ abgleitet.

Für den ersten funktionalen Zusammenhang besteht der Zusammenhang zwischen dem korrigierten Offset und dem Ladungsdurchsatz seit der letzten Vollladung oder längeren Ruhephase. Für den zweiten funktionalen Zusammenhang wird der korrigierte Offset über dem gesamten Ladungsdurchsatz aufgetragen.

Für die gesamte Entladekennlinie gilt dann:

Geradenabschnitt c1):        $U_0 = a_1 - b_1 * SOC$

Geradenabschilt c2):        $U_0 = a_2 b_2 * SOC$

Mit der gemessenen Ruhespannung $U_0$, dem Ladezustandswert SOC, dem Offset [mV] $a_1$ und $a_2$ und der Steigung [mV/%] $b_1$ und $b_2$. Der Geradenabschnitt c1) stellt dabei den ersten funktionalen Zusammenhang und der Geradenabschnitt c2) den zweiten funktionalen Zusammenhang dar.

Der Schnittpunkt der beiden Geradenabschnitte c1) und c2) wird dann wie folgt berechnet

$$S_{SOC} = (a_1 - a_2)/(b_1 - b_2)$$

$$S_U = a_1 + b_1 * (a_2 - a_1)/(b_1 - b_2),$$

wobei Ssoc der Ladezustandswert SOC im Schnittpunkt des ersten und zweiten Geradenabschnitts c1), c2) und $S_U$ der Ruhespannungswert $U_0$ im Schnittpunkt des ersten und zweiten Geradenabschnitts c1), c2) ist.

Bei der Ermittlung der Betriebsparameter wird der erste oder zweite funktionale Zusammenhang je nach Ruhespannung $U_0$ berücksichtigt.

Wenn der Ruhespannung $U_0$ größer oder gleich dem Ruhespannungswert $S_U$ im Schnittpunkt ist, wird der erste funktionale Zusammenhang verwendet.

Wenn die Ruhespannung $U_0$ kleiner als die Ruhespannung $S_U$ im Schnittpunkt der ersten und zweiten Geradenabschnitte ist, wird der zweite funktionale Zusammenhang verwendet.

Eine Korrektur findet dann im Verlauf durch die Ladungsumsätze statt, die kontinuierlich berechnet werden.

Der Geradenabschnitt c1) kann durch folgende Parameter beschrieben werden:

Erster funktionaler Zusammenhang:

$$U_0 = a_1 + b_1 * SOC$$

mit

$b_1$=konstant (es wird nur eine Steigung angenommen, $b_1$ kann aber auch für komplexere Betrachtungen variabel sein).
$a_1 = P13_1 * P_1 + P13_2$ (im Bereich des minimalen Offset P10 und maximalen Offiset $P_{11}$)
$P13_1$: Steigung ([V])
$P13_2$: Offset ([V])
$P_2$: Ladungsumsatz seit der letzen Vollladung oder längeren Ruhephase im Bereich [0, $P_{1Max}$]
$P_{10}$: minimaler Offset $U_{0,Offset-min}$
$P_{11}$: maximaler Offset $U_{0,Offset-max}$

Der den zweiten funktionalen Zusammenhang beschreibende Geradenabschnitt c2) kann durch folgende Parameter festgelegt werden:

Zweiter funktionaler Zusammenhang:

$$U_0 = a_2 + b_2 * SOC.$$

beziehungsweise

$$U_0 = a_{21} + b_{21} * SOC$$

mit

$b_{21}$ und $b_{22}$=konstant (es wird nur eine konstante Steigung angenommen, für komplexere Zusammenhänge kann der Faktor aber auch variabel sein)

$$a_{21} = P19_1 * P_2 + P19_2$$

(im Bereich zwischen minimalen und maximalen Offset [$P_{21}$, $P_{22}$])

$$a_{22} = P20_1 * P2 + P20_2$$

(im Bereich zwischen minimalen und maximalen Offset $[P_{21}, P_{22}]$)

P19$_1$:     Steigung/Anstieg 1 ([V])

P19$_2$:     Offset/Anstieg 1 ([V])

P20$_1$:     Steigung/Anstieg 2 ([V])

P20$_2$:     Offset/Anstieg 2 ([V])

P$_2$:     gesamter Ladungsdurchsatz $[0, P_{2Max}]$

P$_{21}$:     minimaler Ruhespannungs-Offset $U_{0,Offset-min}$

P$_{22}$:     maximaler Ruhespannungs-Offset $U_{0,Offset-max}$

Der gesamte Zusammenhang zwischen der Ruhespannung $U_0$ und dem Ladezustand SOC wird somit durch zwei Geraden beschrieben:

Kennlinie 1:     $U_0 = a_1 + b_1 * SOC$

Kennlinie 2:     $U_0 = -a_2 + b_2 * SOC$.

Das Umschalten zwischen den Kennlinien erfolgt am Schnittpunkt... Kennlinien:

$$S_{SOC} = (a_2 - a_1)/(b_1 - b_2),$$

$$S_U = (a_1 + b_1) * (a_2 - a_1)/(b_1 - b_2).$$

Für das Umschalten gilt dann Folgende Bedingungen:

$$U_0 \geq S_U = \rightarrow \text{Kennlinie 1 verwenden}$$

$$U_0 \leq S_U = \rightarrow \text{Kennlinie 2 verwenden}.$$

Hieraus kann die Säurekapazität bestimmt werden durch :

$$C_{0,1} = \frac{S_U - U_{0,1}}{S_{SOC} - SOC_{gem,1}} \rightarrow \text{Kennlinie 1}$$

$$C_{0,2} = \frac{S_U - U_{0,2}}{S_{SOC} - SOC_{gem,2}} \rightarrow \text{Kennlinie 2}$$

mit

S$_U$ :     Spannungswert des Schnittpunktes

U$_{0,1}$ :     korrigierte Ruhespannung auf der Kennlinie 1

S$_{SOC}$ :     Erdezustandswert SOC des Schnittpunktes S

SOC$_{gem,1}$ :     bestimmte Ladezustandswert SOC auf der Kennlinie 1.

Sofern zwei Ruhespannungspunkte und $U_{0,1x}$, $U_{0,2x}$ und der Ladungsumsatz zwischen den Ruhephasen auf dem Geradenabschnitt c1), das heißt im ersten funktionalen Zusammenhang bekannt sind, kann die aktuelle Säurekapazität $C_{0,x}$ der Speicherbatterie und daraus die Ist-Kapazität der Speicherbatterie nach der Beziehung:

$$C_{0,1} = \frac{U_{0,12} - U_{0,22}}{\text{Ladungsumsatz}} \rightarrow \text{Kennlinie 2}$$

$$C_{0,1} = \frac{U_{0,11} - U_{0,21}}{\text{Ladungsumsatz}} \rightarrow \text{Kennlinie 1}$$

bestimmt werden.

### Patentansprüche

1.   Verfahren zur Ermittlung einer <u>Säurekapazität als</u> Betriebsparameter einer elektrochemischen Speicherbatterie <u>ausgebildet durch eine Blei-Säure-Batterie</u> unter Berücksichtigung einer Elektrolytschichtung, **gekennzeichnet durch**

a) Bestimmen eines ersten funktionalen Zusammenhangs in Form eines ersten <u>Geradenabschnitts einer Entladekennlinie</u> zwischen der Ruhespannung $U_0$ und dem Ladezustand SOC als Wert für die entnehmbare Ladung bezogen auf die Nennkapazität $Q_N$ der Speicherbatterie, der sich im Zustand mit Elektrolytschichtung in einer Enttadephase mit dem Ladungsumsatz seit einer vorhergehenden Ruhephase oder Vollladung ergibt;

b) Hestimmen eines zweiten funktionalen Zusammenhangs in Form eines zweiten <u>Geradenabschnitts der Entladekennlinie</u> zwischen der Ruhespannung $U_0$ und dem Ladezustand SOC als Wert für die entnehmbare Ladung bezogen auf die Nennkapazität $Q_N$ der Speicherbatterie, der sich im Zustand mit Elektrolytschichtung in einer Entladephase mit einem gesamten Ladungswnsatz ergibt;

c) Ermitteln der Säurekapazität aus dem Schnittpunkt des ersten und zweiten funktionalen Zusammenhangs und der Steigung von Geraden zur Beschreibung des ersten oder zweiten funktionalen Zusammenhangs.

**2.** Verfahren nach Anspruch 1, **gekennzeichnet durch** Bestimmen eines dritten funktionalen Zusammenhangs in Form einer Geraden zwischen der Ruhespannung $U_0$ und dem Ladezustand SOC als Wert für die entnehmbare Ladung bezogen auf die Nennkapazität $Q_N$ der Speicherbatterie im Zustand ohne Elektrolytschichtuag.

**3.** Verfahren nach Anspruch 2, **gekennzeichnet durch** Bestimmen des Spannungoffsets a und der Steigung b für den ersten und zweiten funktionalen Zusammenhang, wobei der Spannungsoffset a die Spannungsdifferenz zwischen dem Schnittpunkt des ersten und zweiten funktionalen Zusammenhangs und dem dritten funktionalen Zusammenhang im Zustand ohne Elektrolytschichtung ist.

## Claims

**1.** Method for determining an acid capacity as an operating parameter of an electrochemical storage battery formed by a lead-acid battery taking account of electrolyte stratification, **characterized by**

a) determination of a first functional relationship in the form of a first linear section of a discharge characteristic between the rest voltage $U_0$ and the state of charge SOC as a value for the charge which can be drawn with respect to the rated capacity $Q_N$ of the storage battery which results in the state with electrolyte stratification in a discharge phase with the charge throughput since a previous rest phase or full charge;

b) determination of a second functional relationship in the form of a second linear section of the discharge characteristic between the rest voltage $U_0$ and the state of charge SOC as the value for the charge which can be drawn with respect to the rated capacity $Q_N$ of the storage battery which results in the state with electrolyte stratification in a discharge phase with a total charge throughput;

c) determination of the acid capacity from the intersection of the first and second functional relationships and the gradient of the straight lines for describing the first or the second functional relationships.

**2.** Method according to Claim 1, **characterized by** determination of a third functional relationship in the form of a straight line between the rest voltage $U_0$ and the state of charge SOC as the value for the charge which can be drawn with respect to the rated capacity $Q_N$ of the storage battery in the state without electrolyte stratification.

**3.** Method according to Claim 2, **characterized by** determination of the voltage offset a and of the gradient b for the first and second functional relationships, wherein the voltage offset a is the voltage difference between the intersection of the first and second functional relationships and the third functional relationship in the state without electrolyte stratification.

## Revendications

**1.** Procédé de détermination de l'alcalinité en tant que paramètre de fonctionnement d'une batterie d'accumulateur électrochimique constituée d'une batterie à l'acide et au plomb, compte tenu d'une stratification de l'électrolyte, **caractérisé par** les étapes qui consistent à :

a) déterminer une première relation fonctionnelle sous la forme d'un premier tronçon rectiligne d'une ligne caractéristique de décharge entre la tension au repos $U_0$ et l'état de charge SOC, en tant que valeur de la charge prélevable rapportée à la capacité nominale $Q_N$ de la batterie d'accumulation qui s'établit dans des situations où l'électrolyte est stratifié dans une phase de décharge avec le coefficient de charge depuis une phase antérieure de repos ou la charge complète,

b) déterminer une deuxième relation fonctionnelle sous la forme d'une deuxième partie rectiligne de la ligne caractéristique de décharge entre la tension au repos $U_0$ et l'état de charge SOC, en tant que valeur de la charge prélevable rapportée à la capacité nominale $Q_N$ de la batterie d'accumulateur, qui s'établit dans une situation où l'électrolyte est stratifié au cours d'une phase de décharge avec un coefficient complet de charge,

c) déterminer l'alcalinité à partir du point de concours entre la première et la deuxième relation fonctionnelle et la pente des droites qui décrivent la première ou la deuxième relation fonctionnelle.

**2.** Procédé selon la revendication 1, **caractérisé par** l'étape qui consiste à déterminer une troisième relation fonctionnelle sous la forme d'une droite entre la tension au repos $U_0$ et l'état de charge SOC en tant que valeur de la charge prélevable rapportée à la capacité nominale $Q_N$ de la batterie d'accumulation dans des situations où l'électrolyte est stratifié.

3. Procédé selon la revendication 2, **caractérisé par** l'étape qui consiste à déterminer le décalage de tension a et la pente b de la première et de la deuxième relation fonctionnelle, le décalage de tension a étant la différence de tension entre le point de concours de la première et de la deuxième relation fonctionnelle et la troisième relation fonctionnelle dans une situation où l'électrolyte n'est pas stratifié.

Strom             $I_{Batt}$

Spannung $U_{00}$ bzw. $U_{Batt}$

Nennkapazität      $Q_N$

1

Korrigierte
Ruhespannung $U_0$

Säurekapazität $C_0$

Entnehmbare
Ladung Q

## Fig. 1

$U_0$

a)

c1)

b)

c)

c2)

SOC

## Fig. 2

$U_0$

Steigende Schichtung

c1)

a)

SOC

=> erster funktionaler Zusammenhang

Fig. 3

$U_0$

Verringerung der Elektrolytmenge
und Verringerung der Elektrolytkonzentration

a)

c2)

SOC

=> zweiter funktionaler Zusammenhang

Fig. 4

Fig. 5

$$\Rightarrow a_1 = \overline{P_{13_1} \ast P_2} + P_{13_2}$$

Fig. 6

Fig. 7

Fig. 8

$$\Rightarrow a_{21} = P_{19_1} * P_1 + P_{19_2}$$

$$\Rightarrow a_{22} = P_{20_1} * P_1 + P_{20_2}$$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10106508